# EUROPÄISCHE PATENTSCHRIFT

(11) **EP 3 300 538 B1**
(45) Veröffentlichungstag und Bekanntmachung des Hinweises auf die Patenterteilung: **28.06.2023**
(21) Anmeldenummer: 16726058.7
(22) Anmeldetag: 23.05.2016
(51) Int. Cl.: H02H 1/00, H01H 33/26, H02B 13/065, G01R 31/12, H02H 7/22, H01H 83/20, G01R 31/14, G01N 21/3504, G01R 31/34, G01N 21/67

(54) **VORRICHTUNG ZUR ERKENNUNG EINES STÖRLICHTBOGENS UND ELEKTRISCHE SCHALTANLAGE AUF BASIS VON ABSORPTIONSLINIEN**
DEVICE FOR RECOGNIZING AN ARCING FAULT, AND ELECTRICAL SWITCHGEAR
DISPOSITIF PERMETTANT D'IDENTIFIER UN ARC ÉLECTRIQUE PARASITE ET INSTALLATION DE DISTRIBUTION ÉLECTRIQUE

(30) Priorität: 15.09.2015 DE 102015217633
(43) Veröffentlichungstag der Anmeldung: 04.04.2018
(73) Patentinhaber: Siemens Aktiengesellschaft, 80333 München (DE)
(72) Erfinder: LECHELER, Stefan, 12277 Berlin (DE)
(74) Vertreter: Siemens Patent Attorneys
(86) Internationale Anmeldenummer: PCT/EP2016/061557
(87) Internationale Veröffentlichungsnummer: WO 2017/045778

(56) Entgegenhaltungen:
- WO-A1-2010/015269
- DE-U1- 29 502 452

## Beschreibung

Die Erfindung betrifft eine Vorrichtung zur Erkennung eines Störlichtbogens sowie eine elektrische Schaltanlage mit solch einer Vorrichtung.

Störlichtbögen sollten in elektrischen Schaltanlagen sicher erkannt werden. Vor allem müssen Störlichtbögen von sonstigen Lichterscheinungen unterschieden werden können, um gezielte Maßnahmen zur Reduzierung des Schadens durch die Wirkdauer des Störlichtbogens einleiten zu können.

Störlichtbögen können aufgrund verschiedenster Ereignisse in elektrischen Schaltanlagen auftreten. Beispielsweise können Störlichtbögen durch Überspannungseffekte zwischen verschiedenen Phasen bzw. zwischen einer stromleitenden Phase und einer Erdung beispielsweise des Gehäuses auftreten. Zusätzlich können Störlichtbögen beispielsweise durch Verschmutzung verstärkt auftreten, da sich durch eine Verschmutzung die Leitfähigkeit von Oberflächen in elektrischen Schaltanlagen ändern und erhöhen können.

Des Weiteren können Störlichtbögen nach Wartungen von elektrischen Schaltanlagen auftreten, wenn beispielsweise Werkzeug unbeabsichtigt in der elektrischen Schaltanlage verbleibt und dieses Werkzeug in Kontakt zu stromführenden Teilen tritt. Ebenso ist es möglich, dass beispielsweise aufgrund von Erschütterungen durch das Schalten der elektrischen Schalter in den Schaltanlagen verbliebenes Werkzeug die Position ändert und erst nach solch einem Ereignis das Werkzeug so in der elektrischen Schaltanlage platziert ist, dass Störlichtbögen auftreten können.

Übliche Lösungen zur Erkennung von Störlichtbögen messen lediglich das Auftreten von Lichteffekten in elektrischen Schaltanlagen, was zur sicheren Erkennung eines Störlichtbogens nicht ausreichend ist, da Lichteffekte auch durch Fremdlichteinwirkung ohne Vorhandensein eines Störlichtbogens auftreten können. Deshalb wird zusätzlich mindestens eine zweite Messgröße zusammen mit dem Lichtsignal verknüpft, um eine Entscheidung treffen zu können, ob ein Störlichtbogen vorliegt oder nicht.

Die zweite Messgröße kann beispielsweise aufgrund der Überwachung des Stromflusses in der Schaltanlage gebildet werden und es kann bei einem schnell ansteigenden Strom in Verbindung mit dem Lichteffekt die Entscheidung getroffen werden, ob ein Störlichtbogen vorliegt oder nicht. Ebenso ist es möglich, als weitere Messgröße den Luftdruck zu überwachen und bei einem schnellen Druckanstieg in Verbindung mit dem Lichteffekt die Entscheidung zu treffen, ob ein Störlichtbogen vorliegt oder nicht.

Falls das Ereignis eines Störlichtbogens in einer elektrischen Schaltanlage auftritt, müssen möglichst schnell Gegenmaßnahmen eingeleitet werden, da ansonsten die elektrische Anlage durch verdampfendes Metall stark geschädigt wird. Die Überwachung des Stromes auf ein Überstromkriterium und ebenso die Messung des Drucks veranschlagen mehr als 10 ms (Millisekunden) und sind daher oftmals zu langsam und erkennen zu spät einen Störlichtbogen.

In der DE 295 02 452 U1 wird eine Anordnung zur raumselektiven Erfassung von Störlichtbögen in Schaltanlagen offenbart. Die Anordnung zur raumselektiven Erfassung besteht aus Lichtbogendetektoren mit Lichtwellenleitern, in die die optische Eigenstrahlung eines Störlichtbogens eingekoppelt wird, wobei die Anordnung aus mindestens einer spektral selektivarbeitenden Empfangseinrichtung, aus mindestens einem nicht spektral selektiv arbeitenden optischen Empfangsmodul und einem Logikteil zur logischen Verknüpfung der Signale der Empfangseinrichtung und des Empfangsmoduls besteht, wobei die Empfangsflächen der Lichtwellenleiter in abgeschotteten Räumen der Schaltanlage angeordnet sind, und wobei die einzelnen den Räumen zugeordneten Lichtwellenleitern getrennten Empfangselementen des Empfangsmoduls zugeordnet sind, während ein aus den einzelnen Räumen abgeleitetes Summensignal der Empfangseinrichtung zugeführt wird.

In der WO 2010/015269 A1 wird ein Verfahren zum Überwachen des Betriebszustands einer elektrischen Maschine beschrieben. Das Verfahren zum Überwachen des Betriebszustands erfasst eine Strahlungsintensität selektiv in einem Wellenlängenbereich eines Absorptionsbands eines Ionisationsprodukts durch einen Infrarotsensor, der über einen Luftspalt auf mindestens einen Teil der elektrischen Maschine ausgerichtet ist, und mindestens einen Parameter für die Teilentladungsaktivität innerhalb der elektrischen Maschine aus der gemessenen Strahlungsintensität als Maß für den Betriebszustand der elektrischen Maschine ermittelt.

Der Erfindung liegt daher die Aufgabe zugrunde, eine Vorrichtung zur Erkennung eines Störlichtbogens und eine elektrische Schaltanlage mit solch einer Vorrichtung zur Verfügung zu stellen, die alternativ schnell und sehr zuverlässig einen Lichtbogen erkennen kann und entsprechende Gegenmaßnahmen einleiten kann.

Diese Aufgabe wird erfindungsgemäß durch die Schaltanlage Vorteilhafte Ausgestaltungen der elektrischen Schaltanlage sind in Unteransprüchen angegeben.

Die Schaltanlage gemäß Anspruch 1 umfasst einen Sensor zur Detektion von Absorptionslinien des einfallenden Lichts und eine Auswerteeinheit, die bei Vorhandensein von charakteristischen Absorptionslinien ein Auswertesignal erzeugt. Vorteilhaft hierbei ist, dass die erfindungsgemäße Vorrichtung sehr zuverlässig einen Störlichtbogen daran erkennt, da das vom Störlichtbogen verdampftes Material mittels Absorptionslinien detektiert wird. Weitere Messgröße müssen nicht aufgenommen und ausgewertet werden.

In einer Ausgestaltung liegt das Auswertesignal an einem Ausgang der Auswerteeinheit an.

In einer weiteren Ausgestaltung umfasst der Sensor ein Sensorfenster, durch das das einfallende Licht detektiert wird.

In einer weiteren Ausgestaltung wird das Auswertesignal bei Vorhandensein von Absorptionslinien von Kupfer, Aluminium oder Eisen (Cu, Al, Fe) erzeugt.

In einer Ausgestaltung detektiert der Sensor Fraunhoferlinien.

In einer Ausgestaltung der elektrischen Schaltanlage löst das Auswertesignal Gegenmaßnahmen zur Verminderung und/oder zum Löschen des Störlichtbogens aus.

In einer weiteren Ausgestaltung ist der Sensor der Vorrichtung zur Erkennung eines Störlichtbogens innerhalb der elektrischen Schaltanlage angeordnet.

In einer Ausgestaltung umfasst die elektrische Schaltanlage Stromschienen, die aus Kupfer oder Aluminium (Cu, Al) gefertigt sind. Ebenso kann die elektrische Schaltanlage ein Gehäuse umfassen, welches aus Eisen oder Stahl gefertigt ist.

In einer weiteren Ausgestaltung kann die Auswerteeinheit innerhalb weniger ms (Millisekunden) ein Auswertesignal erzeugen. Die Auswerteeinheit kann zwischen 3 ms und 6 ms ein Auswertesignal erzeugen.

In einer Ausgestaltung detektiert der Sensor Fraunhoferlinien der in der Schaltanlage verwendeten Metalle (z.B. Cu, Al, Fe) .

Die oben beschriebenen Eigenschaften, Merkmale und Vorteile dieser Erfindung, sowie die Art und Weise, wie sie erreicht werden, werden klarer und deutlicher verständlich im Zusammenhang mit der folgenden Beschreibung der Ausführungsbeispiele, die in Zusammenhang mit den Figuren näher erläutert werden.

Dabei zeigen:
- Figur 1: Vorrichtung umfassend einen Sensor und eine Auswerteeinheit;
- Figur 2: Schaltanlage mit Vorrichtung zur Erkennung eines Störlichtbogens, wobei die Auswerteeinheit außerhalb der Schaltanlage angeordnet ist; und
- Figur 3: Schaltanlage mit Vorrichtung zur Erkennung eines Störlichtbogens, wobei die Auswerteeinheit innerhalb der Schaltanlage angeordnet ist.

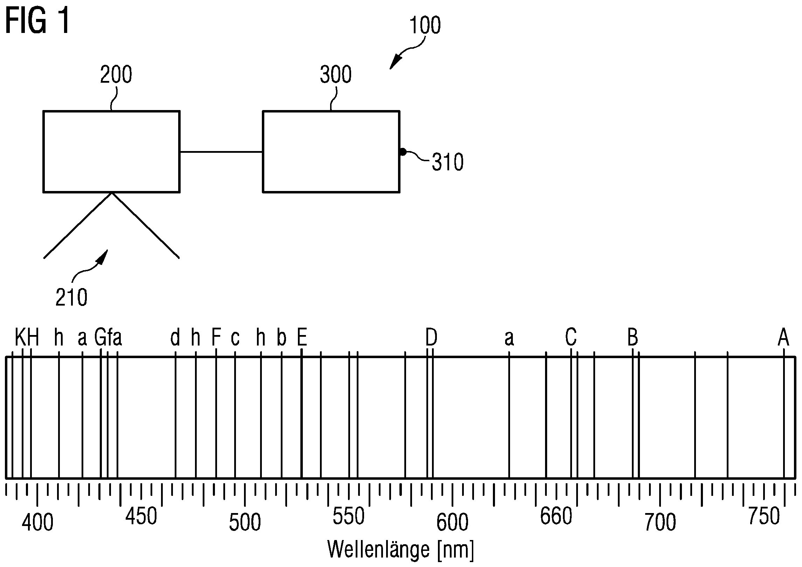

In Figur 1 ist die Vorrichtung 100 zur Erfassung eines Störlichtbogens in einfallendem Licht dargestellt. Die Vorrichtung 100 umfasst dazu einen Sensor 200 zur Detektion von Absorptionslinien des einfallenden Lichts. Dazu kann der Sensor 200 ein Sensorfenster 210 enthalten, durch das das einfallende Licht detektiert wird.

Die Vorrichtung 100 zur Erkennung eines Störlichtbogens in einfallendem Licht umfasst zusätzlich eine Auswerteeinheit 300, die bei Vorhandensein von charakteristischen Absorptionslinien ein Auswertesignal erzeugt. Dieses Auswertesignal kann beispielsweise an einem Ausgang 310 der Auswerteeinheit 300 anliegen und entsprechend weiterverarbeitet werden.

Der Sensor 200 kann beispielsweise Fraunhoferlinien detektieren, die Absorptionslinien des einfallenden Lichts darstellen. In folgender Tabelle sind die wichtigsten Fraunhoferlinien bei ihrer Wellenlänge in nm (Nanometer) und die zugeordneten Elemente dargestellt.

Tabelle Fraunhoferlinien (Quelle: wikipedia.de):

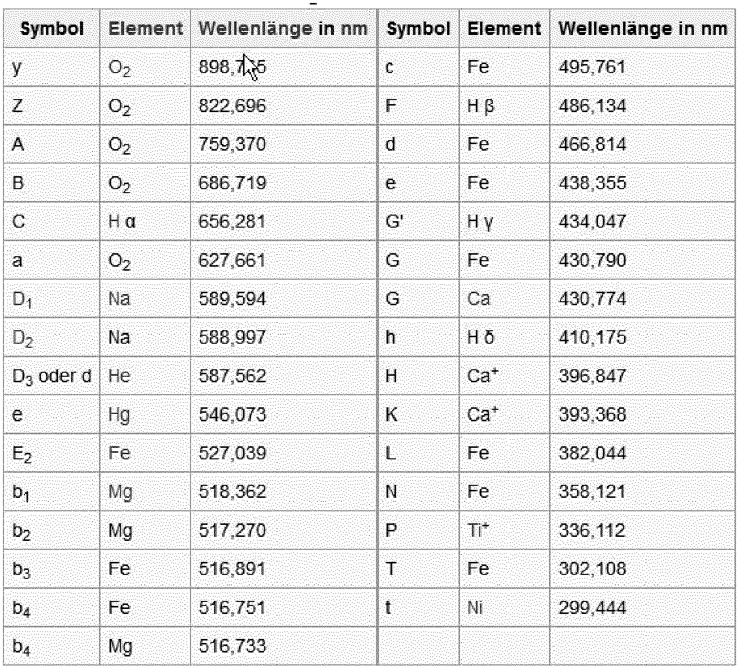

Die Vorrichtung 100 zur Erkennung eines Störlichtbogens kann speziell beim Vorhandensein von Absorptionslinien von Kupfer, Aluminium oder Eisen das Auswertesignal erzeugen.

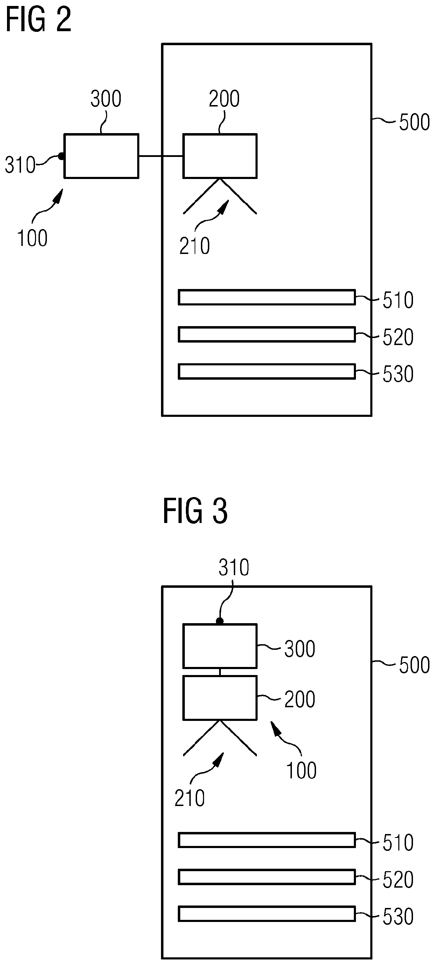

In Figur 2 ist eine elektrische Schaltanlage mit einer Vorrichtung 100 zur Erkennung eines Störlichtbogens dargestellt. Der Sensor 200 der Vorrichtung 100 zur Erkennung eines Störlichtbogens detektiert dabei das Licht innerhalb der elektrischen Schaltanlage 500. Dies kann beispielsweise so gestaltet sein, dass sich der Sensor 200 in der elektrischen Schaltanlage 500 befindet. Ebenso ist denkbar, dass der Sensor 200 das Licht innerhalb der elektrischen Schaltanlage 500 durch ein Fenster detektiert, der Sensor 200 aber außerhalb der elektrischen Schaltanlage 500 angeordnet ist.

Die Auswerteeinheit 300, von der das Auswertesignal erzeugt wird, ist gemäß Figur 2 außerhalb der elektrischen Schaltanlage 500 angeordnet. Das Auswertesignal, welches am Ausgang 310 der Auswerteeinheit 300 anliegen kann, kann weiterverarbeitet werden zur Auslösung von Gegenmaßnahmen zur Verminderung oder zum Löschen des Störlichtbogens. Beispielsweise kann beim Anliegen des Auswertesignals der Strom der elektrischen Schaltanlage 500 ausgeschaltet oder reduziert werden.

Die elektrische Schaltanlage 500 umfasst Stromschienen 510, 520; 530, die beispielsweise aus Kupfer oder Aluminium gefertigt sind. Bei Auftreten eines Störlichtbogens an den Stromschienen 510; 520; 530 wird das Material, aus denen die Stromschienen 510; 520; 530 gefertigt sind, verdampft. Somit werden vom Sensor 200 die charakteristischen Absorptionslinien der Elemente Kupfer oder Aluminium detektiert.

Die elektrische Schaltanlage kann ein Gehäuse umfassen, welches aus Eisen oder Stahl gefertigt ist. Wenn nun ein Störlichtbogen am Gehäuse der elektrischen Schaltanlage 500 auftritt, so wird der Sensor 200 die charakteristischen Absorptionslinien von Eisen detektieren und ein Auswertesignal erzeugen.

Die Auswerteeinheit 300 kann so ausgebildet sein, dass sie ebenso innerhalb der elektrischen Schaltanlage 500 angeordnet ist, wie es in Figur 3 dargestellt ist. Die Auswerteeinheit 300 kann innerhalb weniger ms ein Auswertesignal erzeugen. Bevorzugt kann die Auswerteeinheit 300 ein Auswertesignal innerhalb von 3 ms bis 6 ms erzeugen.

Als Gegenmaßnahme zur Verminderung und/oder zum Löschen des Störlichtbogens kann von der Auswerteeinheit 300 bei Erzeugen des Auswertesignals ebenfalls ein Umschalten auf einen niederohmigen Pfad erfolgen, so dass durch diese Schnellerdung der Störlichtbogen gelöscht wird.

Die sichere Unterscheidung eines Störlichtbogens von sonstigen Lichteffekten erfolgt aufgrund der Auswertung der Fraunhoferlinien des festgestellten Lichts. Sind die in der elektrischen Schaltanlage 500 verwendeten Metalle der Stromschienen 510; 520; 530 wie beispielsweise Kupfer oder Aluminium und/oder der leitenden Umhüllung, wie beispielsweise Eisen, im Spektrum vorhanden, kann sicher davon ausgegangen werden, dass ein Störlichtbogen vorliegt. In so einem Fall kann ohne zusätzliche Absicherung durch ein zweites oder drittes Messverfahren eine Gegenmaßnahme eingeleitet werden wie beispielsweise das Abschalten bzw. Reduzieren des Stromes oder die Schnellerdung.

Vorteilhaft bei der Vorrichtung 100 zur Erkennung eines Störlichtbogens in einfallendem Licht ist, dass ein weiteres Messverfahren zur sicheren Detektierung eines Störlichtbogens entfällt. Die Erkennung des Störlichtbogens kann in Microsekunden erfolgen, die Berücksichtigung eines weiteren Indizes wie Überstrom oder Druckanstieg, welche mehrere Millisekunden dauert, ist nicht notwendig zur sicheren Detektion des Störlichtbogens. Durch die Verwendung der Vorrichtung 100 zur Erkennung eines Störlichtbogens können Gegenmaßnahmen zum Löschen des Störlichtbogens viel eher erfolgen und somit der Schaden in der elektrischen Schaltanlage 500 stark minimiert werden.

## Patentansprüche

1. Elektrische Schaltanlage (500) mit einer Vorrichtung (100) zur Erkennung eines Störlichtbogens, wobei der Sensor (200) der Vorrichtung (100) das Licht innerhalb der elektrischen Schaltanlage (500) detektiert, **gekennzeichnet durch** eine Vorrichtung (100) zur Erkennung eines Störlichtbogens in einfallendem Licht umfassend
- einen Sensor (200) zur Detektion von Absorptionslinien des einfallenden Lichts; und
- eine Auswerteeinheit (300), die bei Vorhandensein von charakteristischen Absorptionslinien ein Auswertesignal erzeugt,
wobei das Auswertesignal Gegenmaßnahmen zur Verminderung und/oder zum Löschen des Störlichtbogens auslöst.

2. Elektrische Schaltanlage (500) gemäß Anspruch 1, bei der das Auswertesignal an einem Ausgang (310) der Auswerteeinheit (300) anliegt.

3. Elektrische Schaltanlage (500) gemäß Anspruch 1 oder 2, bei der der Sensor (200) ein Sensorfenster (210) umfasst, durch das das einfallende Licht detektiert wird.

4. Elektrische Schaltanlage (500) gemäß einem der Ansprüche 1 bis 3, bei dem das Auswertesignal bei Vorhandensein von Absorptionslinien von Cu, Al oder Fe erzeugt wird.

5. Elektrische Schaltanlage (500) gemäß einem der Ansprüche 1 bis 4, bei dem der Sensor (200) Fraunhoferlinien detektiert.

6. Elektrische Schaltanlage (500) gemäß Anspruch 1, bei der der Sensor (200) der Vorrichtung (100) innerhalb der elektrischen Schaltanlage (500) angeordnet ist.

7. Elektrische Schaltanlage (500) gemäß einem der Ansprüche 1 bis 6, wobei die elektrische Schaltanlage (500) Stromschienen (510; 520; 530) umfasst, die aus Cu oder Al gefertigt sind.

8. Elektrische Schaltanlage (500) gemäß einem der Ansprüche 1 bis 7, wobei die elektrische Schaltanlage (500) ein Gehäuse umfasst, welches auch aus Fe oder Stahl gefertigt ist.

9. Elektrische Schaltanlage (500) gemäß einem der Ansprüche 1 bis 8, bei der die Auswerteeinheit (300) innerhalb weniger ms ein Auswertesignal erzeugen kann.

10. Elektrische Schaltanlage (500) gemäß Anspruch 9, bei der die Auswerteeinheit (300) zwischen 3 ms und 6 ms ein Auswertesignal erzeugen kann.

11. Elektrische Schaltanlage (500) gemäß einem der Ansprüche 1 bis 10, bei der der Sensor (200) Fraunhoferlinien der in der elektrischen Schaltanlage (500) verwendeten Metalle detektiert.

## Claims

1. Electrical switchgear (500) incorporating a device (100) for recognizing an arcing fault, wherein the sensor (200) of the device (100) detects the light within the electrical switchgear (500), **characterized by** a device (100) for recognizing an arcing fault in incident light, comprising
- a sensor (200) for detecting absorption lines of the incident light; and
- an evaluation unit (300) which generates an evaluation signal when characteristic absorption lines are present,
wherein the evaluation signal initiates countermeasures for the reduction and/or for the clearance of the arcing fault.

2. Electrical switchgear (500) according to Claim 1, wherein the evaluation signal is present at an output (310) of the evaluation unit (300).

3. Electrical switchgear (500) according to Claim 1 or 2, wherein the sensor (200) comprises a sensor window (210), through which the incident light is detected.

4. Electrical switchgear (500) according to one of Claims 1 to 3, wherein the evaluation signal is generated in response to the presence of absorption lines for Cu, Al or Fe.

5. Electrical switchgear (500) according to one of Claims 1 to 4, wherein the sensor (200) detects Fraunhofer lines.

6. Electrical switchgear (500) according to Claim 1, wherein the sensor (200) of the device (100) is arranged within the electrical switchgear (500).

7. Electrical switchgear (500) according to one of Claims 1 to 6, wherein the electrical switchgear (500) comprises conductor rails (510; 520; 530) which are formed of Cu or Al.

8. Electrical switchgear (500) according to one of Claims 1 to 7, wherein the electrical switchgear (500) comprises a housing which is formed of Fe or steel.

9. Electrical switchgear (500) according to one of Claims 1 to 7, wherein the evaluation unit (300) can generate an evaluation signal within a few ms.

10. Electrical switchgear (500) according to Claim 9, wherein the evaluation unit (300) can generate an evaluation signal within a time of 3 ms to 6 ms.

11. Electrical switchgear (500) according to one of Claims 1 to 10, wherein the sensor (200) detects Fraunhofer lines for the metals which are employed in the electrical switchgear (500) .

## Revendications

1. Installation de commutation électrique (500) avec un dispositif (100) pour l'identification d'un arc électrique parasite, dans laquelle le détecteur (200) du dispositif (100) détecte la lumière à l'intérieur de l'installation de commutation électrique (500), **caractérisée par** un dispositif (100) pour l'identification d'un arc électrique parasite dans la lumière incidente comportant
- un détecteur (200) pour la détection de raies d'absorption de la lumière incidente ; et
- une unité d'évaluation (300), laquelle produit un signal d'évaluation en présence de raies d'absorption caractéristiques,
dans laquelle le signal d'évaluation déclenche des contre-mesures pour la réduction et/ou pour la suppression de l'arc électrique parasite.

2. Installation de commutation électrique (500) selon la revendication 1, dans laquelle le signal d'évaluation s'applique à une sortie (310) de l'unité d'évaluation (300).

3. Installation de commutation électrique (500) selon la revendication 1 ou la revendication 2, dans laquelle le détecteur (200) comporte une fenêtre de détecteur (210), à travers laquelle la lumière incidente est détectée.

4. Installation de commutation électrique (500) selon l'une des revendications 1 à 3, dans laquelle le signal d'évaluation est produit en présence de raies d'absorption de Cu, d'Al ou de Fe.

5. Installation de commutation électrique (500) selon l'une des revendications 1 à 4, dans laquelle le détecteur (200) détecte des raies de Fraunhofer.

6. Installation de commutation électrique (500) selon la revendication 1, dans laquelle le détecteur (200) du dispositif (100) est disposé à l'intérieur de l'installation de commutation électrique (500).

7. Installation de commutation électrique (500) selon l'une des revendications 1 à 6, dans laquelle l'installation de commutation électrique (500) comporte des rails conducteurs (510 ; 520 ; 530), lesquels sont fabriqués à partir de Cu ou d'Al.

8. Installation de commutation électrique (500) selon l'une des revendications 1 à 7, dans laquelle l'installation de commutation électrique (500) comporte un boîtier, lequel est également fabriqué à partir de Fe ou d'acier.

9. Installation de commutation électrique (500) selon l'une des revendications 1 à 8, dans laquelle l'unité d'évaluation (300) peut produire un signal d'évaluation en quelques ms.

10. Installation de commutation électrique (500) selon la revendication 9, dans laquelle l'unité d'évaluation (300) peut produire un signal d'évaluation dans un délai compris entre 3 ms et 6 ms.

11. Installation de commutation électrique (500) selon l'une des revendications 1 à 10, dans laquelle le détecteur (200) détecte des raies de Fraunhofer des métaux utilisés dans l'installation de commutation électrique (500).
